# EUROPEAN PATENT APPLICATION

(11) **EP 4 734 150 A1**
(43) Date of publication of application: **29.04.2026**
(21) Application number: 24825533.3
(22) Date of filing: 29.03.2024
(51) Int. Cl.: H01L 21/304, B23K 26/53, B24B 27/06, B24D 5/00, B28D 5/04

(54) **MANUFACTURING DEVICE AND MANUFACTURING METHOD FOR SEMICONDUCTOR CRYSTAL WAFER**

(30) Priority: 23.06.2023 JP 2023103521; 28.11.2023 JP 2023200298
(71) Applicant: Drychemicals Co., Ltd., Natori-shi, Miyagi 981-1238 (JP)
(72) Inventor: CHIBA, Tetsuya, Natori-shi, Miyagi 981-1238 (JP); IKEDA, Shinro, Natori-shi, Miyagi 981-1238 (JP)
(74) Representative: Papula Oy
(86) International application number: PCT/JP2024/013048
(87) International publication number: WO 2024/262123

(57) **Abstract**

The purpose of the present invention is to provide a device and a method for manufacturing semiconductor crystal wafer, the device and the method being capable of easily and reliably manufacture semiconductor crystal wafers of high-quality. A manufacturing method for a SiC wafer, which is a semiconductor crystal wafer, comprises a groove machining step (STEP 100/FIG. 1), a guideline forming step (STEP 110/FIG. 1), a cutting step (STEP 120/FIG. 1), and a grinding machining step (STEP 130/FIG1).

## Description

### TECHNICAL FIELD

The present invention relates to a device and a method for manufacturing semiconductor crystal wafer, which cut a semiconductor crystal ingot, that has been ground into a cylindrical shape, into slices as wafers.

### BACKGROUND ART

Conventionally, as for the manufacturing method of SiC wafer of such semiconductor crystal wafer, as shown in the following Patent Document 1, it is known to include a wafer shape forming step, followed by a process-affected layer removal step, and finally a mirror polishing step. The wafer shape forming step includes: an ingot forming step, in which a single crystal SiC block grown by crystallization is processed into a cylindrical ingot; a crystal orientation forming step, in which a notch is formed on a part of the outer periphery of the ingot to become a mark showing a crystal orientation of the ingot; a slicing step, in which the single crystal SiC ingot is sliced into thin disc-shaped SiC wafers; a planarization step, in which the SiC wafers are planarized by using abrasive grains that do not reach the modified Mohs hardness; a mark forming step of forming a mark; and a chamfering step of chamfering the outer peripheral portion. In the process-affected layer removal step, the process-affected layer introduced into the SiC wafer in the previous steps is removed. The mirror polishing step is a chemical mechanical polishing (CMP) step uses both the mechanical action of a polishing pad and the chemical action of slurry to perform polishing.

### [Citation List]

### [Patent Literature]

Patent Document 1: JP 2020-15646 A

### SUMMARY OF INVENTION

### [Technical Problem]

However, with such conventional manufacturing method for SiC wafers, the manufacturing process is complex due to a large number of steps, which leads to a complex device configuration and high manufacturing costs.

On the other hand, if the manufacturing process is simplified, it becomes difficult to stably obtain the required quality for SiC wafers.

Therefore, the present invention aims to provide a manufacturing device and a manufacturing method that can easily and reliably manufacture high-quality semiconductor crystal wafers.

### [Solution to Problem]

A semiconductor crystal wafer manufacturing device of the first invention is a device for manufacturing a semiconductor crystal wafer, which cuts a semiconductor crystal ingot, that has been ground into a cylindrical shape, into slices as wafers, the device comprising:
a guideline forming means for forming cutting guidelines by focusing a laser beam of a wavelength that is transmissive to the semiconductor crystal ingot to form a focal point and scanning the focal point along a planned cutting surface; and
a cutting means for cutting the planned cutting surface of the semiconductor crystal ingot;
wherein the guideline forming means forms the cutting guidelines on the planned cutting surface as scanning lines that correspond to a cutting direction of the cutting means, and the scanning lines coincide with the cutting direction of the cutting means.

According to the semiconductor crystal wafer manufacturing device of the first invention, the cutting guidelines formed on the planned cutting surface serve as cutting guides during the cutting with the cutting means, thereby allowing the cutting means to slice the semiconductor crystal ingot with high precision.

That is, during cutting, the cutting guidelines become regions of low cutting resistance, serving as guides for the cutting means.

Here, by forming the cutting guidelines as scanning lines that correspond to the cutting direction of the cutting means on the planned cutting surface (for example, the scanning lines can be coincident with the cutting direction, orthogonal to the cutting direction, or has a varying density according to the cutting direction), regions of low cutting resistance can be formed to correspond to the cutting direction during cutting with the cutting means.

Furthermore, according to the semiconductor crystal wafer manufacturing device of the first invention and a manufacturing method for a semiconductor crystal wafer of the fifth invention, by forming the cutting guidelines as scanning lines that coincide with the cutting direction of the cutting means, the cutting guidelines, which are regions of low cutting resistance, are continuously formed in the cutting direction during the actual cutting with the cutting means, serving as guides for cutting.

In this way, according to the semiconductor crystal wafer manufacturing device of the first invention, the semiconductor crystal ingot can be cut into slices with high precision, so as to simply and reliably manufacture a high-quality semiconductor crystal wafer.

A semiconductor crystal wafer manufacturing device of the second invention is characterized in that in the first invention, the cutting means is a wire electric discharge machining device that advances a wire while circulating the wire around the planned cutting surface and generates electric discharges from the wire.

According to the semiconductor crystal wafer manufacturing device of the second invention, it is preferable for the cutting means to be a wire electric discharge machining device, as it allows the semiconductor crystal ingot to be cut into slices with high precision.

In this way, according to the the semiconductor crystal wafer manufacturing device of the second invention, the semiconductor crystal ingot can be cut into slices with high precision, so as to simply and reliably manufacture a high-quality semiconductor crystal wafer.

A semiconductor crystal wafer manufacturing device of the third invention is characterized in that in the first invention, the cutting means is a cutter device that advances a cutting blade along the planned cutting surface.

According to the semiconductor crystal wafer manufacturing device of the third invention, it is preferable for the cutting means to be a cutter device, as it allows the semiconductor crystal ingot to be cut into slices with high precision.

In this way, according to the semiconductor crystal wafer manufacturing device of the third invention, the semiconductor crystal ingot can be cut into slices with high precision, so as to simply and reliably manufacture a high-quality semiconductor crystal wafer.

A semiconductor crystal wafer manufacturing device of the fourth invention is a device for manufacturing a semiconductor crystal wafer, which cuts a semiconductor crystal ingot, that has been ground into a cylindrical shape, into slices as wafers, the device comprising:
a groove machining drum grindstone for forming a plurality of concave grooves surrounding an entire side surface of the semiconductor crystal ingot, wherein the groove machining drum grindstone has a plurality of convex portions formed on its side surface corresponding to the plurality of concave grooves;
a wire saw device for cutting the semiconductor crystal ingot into slices by advancing a plurality of wires arranged in the plurality of concave grooves while circulating the plurality of wires; and
a guideline forming means for forming cutting guidelines on each planned cutting surface, including each of the concave grooves formed on the side surface of the semiconductor crystal ingot, by focusing a laser beam of a wavelength transmissive to the semiconductor crystal ingot to form a focal point and scanning the focal point along the planned cutting surface;
wherein the guideline forming means forms the cutting guidelines in a scanning direction that corresponds to an advancing direction of the plurality of wires of the wire saw device, and the scanning direction coincides with the advancing direction of the plurality of wires.

The semiconductor crystal wafer manufacturing device of the fourth invention is composed of a groove machining drum grindstone with a plurality of convex portions formed on its side surface corresponding to a plurality of concave grooves formed on the entire side surface of the semiconductor crystal ingot, and corresponding additional machine parts.

A first additional machine part is a wire saw device that circulates a plurality of wires arranged in the plurality of concave grooves formed on the entire side surface of the semiconductor crystal ingot.

A second additional machine part is a guideline forming means that forms cutting guidelines on each planned cutting surface, including each concave groove, by focusing a laser beam of a transmissive wavelength to form a focal point and scanning the focal point along the planned cutting surface.

In the above configuration, the plurality of wires are accurately arranged in the plurality of concave grooves formed on the entire side surface of the semiconductor crystal ingot by the groove machining drum grindstone, and the cutting guidelines formed on each planned cutting surface serve as cutting guides during cutting with the wires, thereby allowing the semiconductor crystal ingot to be cut into slices with high precision using the plurality of wires.

That is, as a plurality of wires, arranged in a plurality of concave grooves, advance while circulating during cutting, the concave grooves in a pre-cutting section and the cutting guidelines form regions of low cutting resistance, which serves as guides for the cutting.

By forming the cutting guidelines to correspond to the traveling direction of the plurality of wires, regions of low cutting resistance can be continuously provided to the plurality of wires during their travel.

Furthermore, according to the semiconductor crystal wafer manufacturing device of the fourth invention, by forming the cutting guidelines to coincide with the traveling direction of the plurality of wires, regions of low cutting resistance can be continuously provided to the plurality of wires during their actual travel.

In this way, according to the semiconductor crystal wafer manufacturing device of the fourth invention, the semiconductor crystal ingot can be cut into slices with high precision, so as to simply and reliably manufacture a high-quality semiconductor crystal wafer.

A semiconductor crystal wafer manufacturing device of the fifth invention is the device according to any one of the first to fourth invention, wherein the guideline forming means introduces the laser beam from an end surface of the semiconductor crystal ingot.

According to the semiconductor crystal wafer manufacturing device of the fifth invention, by introducing the laser beam for forming the cutting guidelines from an end surface of the semiconductor crystal ingot, the cutting guideline can be formed easily and reliably by determining a distance to the focal point and maintaining that distance while the laser beam scans along the traveling direction of the plurality of wires.

In this way, according to the semiconductor crystal wafer manufacturing device of the fifth invention, cutting guidelines can be formed easily and reliably, thereby allowing the semiconductor crystal ingot to be cut into slices with high precision, so as to simply and reliably manufacture a high-quality semiconductor crystal wafer.

A semiconductor crystal wafer manufacturing method of the sixth invention is a method for manufacturing a semiconductor crystal wafer, which cuts a semiconductor crystal ingot, that has been ground into a cylindrical shape, into slices as wafers, the method comprising:
a guideline forming step of forming cutting guidelines by focusing a laser beam of a wavelength transmissive to the semiconductor crystal ingot to form a focal point and scanning the focal point along a planned cutting surface; and
a cutting step of cutting the planned cutting surface of the semiconductor crystal ingot;
wherein the guideline forming step forms the cutting guidelines on the planned cutting surface as scanning lines that correspond to a cutting direction of the cutting step, and the scanning lines coincide with the cutting direction of the cutting step.

According to semiconductor crystal wafer manufacturing method of the sixth invention, the cutting guidelines formed on the planned cutting surface serve as cutting guides during the cutting performed in the cutting step, thereby allowing the semiconductor crystal ingot to be cut into slices with high precision in the cutting step.

That is, during the cutting performed in the cutting step, the cutting guidelines become regions of low cutting resistance, serving as guides for the cutting.

Here, by forming the cutting guidelines as scanning lines that correspond to the cutting direction of the cutting step on the planned cutting surface (for example, the scanning lines can be coincident with the cutting direction, orthogonal to the cutting direction, or has a varying density according to the cutting direction), regions of low cutting resistance can be formed to correspond to the cutting direction during the cutting performed in the cutting step.

Furthermore, according to the semiconductor crystal wafer manufacturing method of the sixth invention, by forming the cutting guidelines as scanning lines that coincide with the cutting direction of the cutting step, the cutting guidelines, which are regions of low cutting resistance, are continuously formed in the cutting direction during the actual cutting performed in the cutting step, serving as cutting guides.

In this way, according to the semiconductor crystal wafer manufacturing method of the sixth invention, the semiconductor crystal ingot can be cut into slices with high precision, so as to simply and reliably manufacture a high-quality semiconductor crystal wafer.

Asemiconductor crystal wafer manufacturing method of the seventh invention is a method for manufacturing a semiconductor crystal wafer, which cuts a semiconductor crystal ingot, that has been ground into a cylindrical shape, into slices as wafers, the method comprising:
a groove machining step of forming a plurality of concave grooves surrounding an entire side surface of the semiconductor crystal ingot;
a guideline forming step of forming cutting guidelines on each planned cutting surface, including each groove formed on the side surface of the semiconductor crystal ingot in the groove machining step, by focusing a laser beam of a wavelength transmissive to the semiconductor crystal ingot to form a focal point and scanning the focal point along the planned cutting surface; and
a cutting step of cutting the semiconductor crystal ingot into slices by advancing a plurality of wires arranged in the plurality of concave grooves formed in the groove machining step while circulating the plurality of wires,
wherein the guideline forming step forms the cutting guidelines in a scanning direction that corresponds to a traveling direction of the plurality of wires in the cutting step, and the scanning direction coincides with the traveling direction of the plurality of wires.

According to the semiconductor crystal wafer manufacturing method of the seventh invention, a groove machining step for forming concave grooves corresponding to the plurality of convex portions of the groove machining drum grindstone on the entire side surface of the semiconductor crystal ingot is performed, followed by a guideline forming step for forming a cutting guideline on each planned cutting surface including each of the plurality of concave grooves formed in the groove machining step, and a cutting step for cutting the semiconductor crystal ingot into slices by advancing a plurality of wires arranged in the plurality of concave grooves formed in the groove machining step while circulating the plurality of wires.

Here, in addition to accurately arranging a plurality of wires in the plurality of concave grooves formed on the entire side surface of the semiconductor crystal ingot by the groove machining drum grindstone, the cutting guideline formed on each planned cutting surface during cutting by the plurality of wires serves as a guide for the cutting, thereby allowing the semiconductor crystal ingot to be cut into slices with high precision using the plurality of wires.

That is, as the plurality of wires, arranged in a plurality of concave grooves, advance while circulating during cutting, the concave grooves and the cutting guidelines form regions of low cutting resistance, which serve as guides for the cutting.

By forming the cutting guidelines in correspondence with the traveling direction of the plurality of wires, regions of low cutting resistance can be continuously provided to the plurality of wires during their travel.

In this way, according to the semiconductor crystal wafer manufacturing method of the seventh invention, the semiconductor crystal ingot can be cut into slices with high precision, so as to simply and reliably manufacture a high-quality semiconductor crystal wafer.

### BRIEF DESCRIPTION OF THE DRAWINGS

FIG. 1 is a flowchart showing an entire process of a manufacturing method of a SiC wafer (semiconductor crystal wafer) according to one embodiment.
FIG. 2 is an explanatory diagram showing details of a groove machining step in the manufacturing method for a SiC wafer of FIG. 1.
FIG. 3 is an explanatory diagram showing details of a guideline forming step and a cutting step in the manufacturing method for a SiC wafer of FIG. 1.
FIG. 4 is an explanatory diagram showing details of a grinding machining step in the manufacturing method for a SiC wafer of FIG. 1.
FIG. 5 is an explanatory diagram showing a modification example of the guideline forming step in the manufacturing method for a SiC wafer of FIG. 1.
FIG. 6 is an explanatory diagram showing a modification example of the guideline forming step in the manufacturing method for a SiC wafer of FIG. 1.

### DESCRIPTION OF EMBODIMENTS

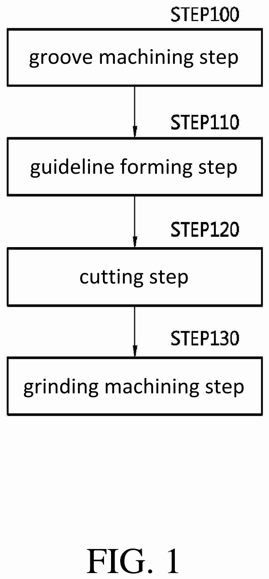

As shown in FIG. 1, in this embodiment, a manufacturing method for a SiC wafer, which is a semiconductor crystal wafer, is a method for obtaining a SiC wafer by slicing a SiC ingot that has been ground into a cylindrical shape. The method comprises a groove machining step (STEP 100/FIG. 1), a guideline forming step (STEP 110/FIG. 1), a cutting step (STEP 120/FIG. 1), and a grinding machining step (STEP 130/FIG. 1).

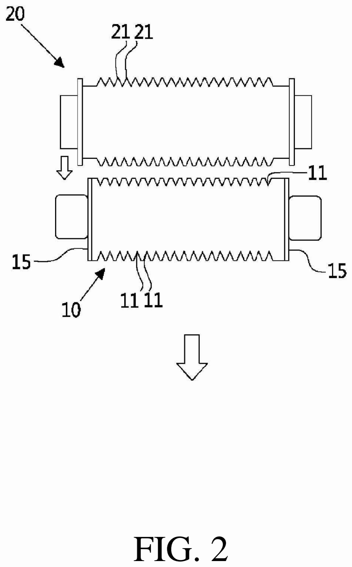

Details of each step and a SiC wafer manufacturing device of this embodiment will be described with reference to FIGs. 2 to 5.

First, in the groove machining step (STEP 100/FIG. 1), a plurality of concave grooves 11 are formed at one time to surround an entire side surface of the SiC ingot 10 by a groove machining drum grindstone 20.

The groove machining drum grindstone 20 is a drum grindstone for forming a plurality of concave grooves 11 surrounding the entire side surface of the SiC ingot 10, and it has a plurality of convex portions 21 on its side surface corresponding to the plurality of concave grooves 11.

Specifically, in the groove machining step (STEP 100/FIG. 1), the groove machining drum grindstones 20, each of which has a plurality of convex portions 21 on its entire side surface corresponding to the plurality of concave grooves 11, are pressed against the SiC ingot 10 while being rotated on their respective rotation axes parallel to each other, thereby forming the plurality of concave grooves 11.

At this time, the SiC ingot 10 is rotatably supported with both end surfaces protected by a pair of protective plates 15, 15.

The protective plates 15 are made of a synthetic resin such as polyvinyl chloride, and bonded to the SiC ingot 10 via an adhesive or the like as needed.

With this pair of protective plates 15, 15, both ends of the SiC ingot 10 can be protected, and chipping or cracking at the ends can be prevented. Therefore, this allows the plurality of concave grooves 11 to be formed up to the very ends, which in turn allows more SiC wafers 100, described below, to be cut and obtained.

Also, when holding and fixing the SiC ingot 10 to the rotation axis, the protective plates 15, 15 can be machined (e.g., drilled) as needed for fixation. In this case as well, since the SiC ingot 10 itself is not machined, the SiC ingot 10 is not damaged.

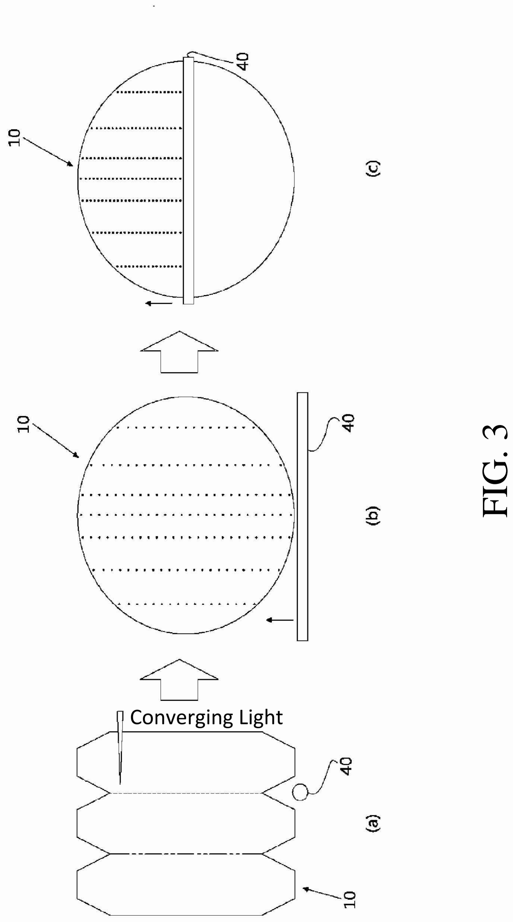

Next, as shown in FIG. 3(a), prior to cutting with a wire 40, a cutting guideline is formed on a planned cutting surface in the guideline forming step (STEP 110/FIG. 1).

The planned cutting surface is a surface that includes each concave groove 11 formed in the groove machining step (STEP 100/FIG. 1) (a circular surface indicated in the figure by a dashed line, whose diameter is reduced radially inward from the outer diameter of the ingot by the groove depth). By positioning a focal point of a laser beam of a wavelength transmissive to the SiC ingot 10 on this planned cutting surface, a modified region of the SiC crystal is partially formed in the SiC ingot 10. Then, a desired cutting guideline is formed by scanning the focal point across the planned cutting surface.

A guideline means for forming such a cutting guideline includes a laser oscillator that emitting the laser beam and a condenser (lens) that focuses the laser beam inside the SiC ingot 10.

Specifically, as shown in the cross-sectional view of the planned cutting surface in FIG. 3(b), a plurality of cutting guidelines are formed by scanning multiple times in the traveling direction of the wire 40, which is indicated by the arrow in the figure. The spacing between these cutting guidelines may be uniform, but it is also possible to have a varying density, where the spacing becomes smaller towards the center and larger towards both sides.

By providing this varying density, while the cutting speed slows down in the center where the amount of cutting is greater as the wire 40 advances (conversely, the cutting speed increases on both sides), causing the wire 40 to curve, regions of low cutting resistance are provided in stages from both sides to the center, which, as shown in FIG. 3(c), prevents the wire 40 from bowing and keeps it straight.

A wire device used in the cutting step (STEP 120/ FIG. 1) that uses the wire 40 (various devices can be adopted) cuts the SiC ingot 10 into slices by advancing and circulating a plurality of wires 40 spanned between wire bobbins and applying a high voltage (high-frequency high voltage) to the plurality of wires 40 to cause electric discharge into the SiC ingot 10.

As the plurality of wires 40, arranged in the plurality of concave grooves 11, advance while circulating and discharging during cutting, the planned cutting surface has a low cutting resistance region due to the plurality of concave grooves 11 (which reduces the outer diameter of the SiC ingot 10) in addition to the cutting guideline, thereby allowing the plurality of wires 40 to cut through the planned cutting surface as if they were gliding.

This allows the SiC ingot 10 to be cut into slices with high precision at one time using the plurality of wires 40 arranged in the plurality of concave grooves 11. That is, the plurality of wires 40 enable high-speed cutting , as well as surface flatness and low-damage machining of the cut surface. In addition, even the SiC ingot 10 with poor crystallinity in its entirety or in specific regions can be sliced to a specified thickness, without being affected by crystal orientation.

Furthermore, because of the low cutting resistance, the diameter of the wire 40 itself can be made smaller, which in turn minimizes the cutting kerf and improves the yield.

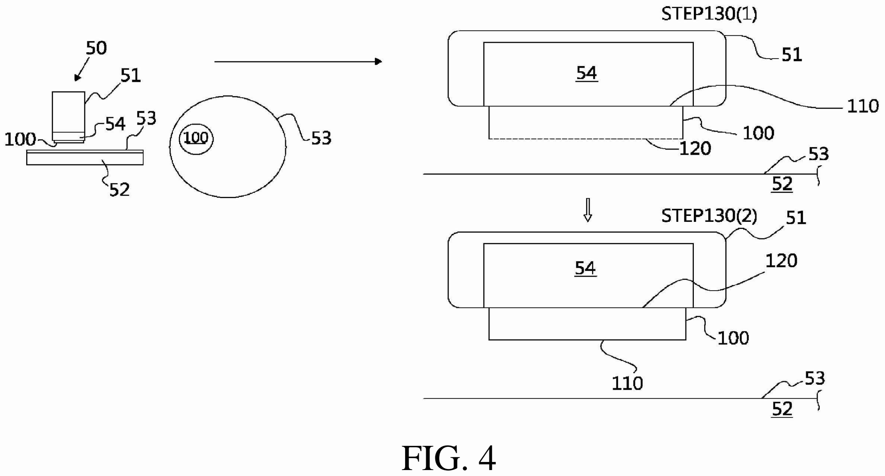

Next, as shown in FIG. 4, in the grinding machining step (STEP 130/FIG. 1), one of the cut surfaces, one surface 110, is used as a support surface, and the other surface 120, is mechanically polished (high precision grinding) in a first surface machining step (STEP 130 (1)).

Specifically, in the first surface machining step (STEP 130 (1)), grinding machining is performed by a mechanical polishing device 50 (ultra-high synthetic high-precision grinding device) that performs mechanical polishing.

The mechanical polishing device 50 comprises a spindle 51 and a diamond grindstone 53 located on a platen 52 of a flat plate.

First, one surface 110 is facing upward and is sucked and supported by a porous vacuum chuck 54, which is a suction plate of the spindle 51, and the other surface 120 is facing downward and is subjected to grinding machining by the diamond grindstone 53.

At this time, the spindle 51 and the diamond grindstone 53 are rotated by a drive device (not shown), and the spindle 51 is pressed against the diamond grindstone 53 by a compressor (not shown) or the like, thereby grinding machining the other surface 120.

After grinding machining, dressing may be performed on the diamond grindstone 53 with a dresser or the like.

Furthermore, the mechanical polishing device 50 may have a functional water supply pipe so that a plurality of types of functional water can be used during machining if necessary.

Next, in a second surface machining step (STEP 130 (2)), the other surface 120, which has been subjected to high-precision grinding machining in the first surface machining step, is facing upward, and one surface 110 is subjected to the same high-precision grinding machining as in the first surface machining step.

That is, the other surface 120 is facing upward and is sucked by the porous vacuum chuck 54, which is the suction plate of the spindle 51, and one surface 110 is facing downward and is subjected to grinding machining by the diamond grindstone 53.

In this case as well, dressing may be performed by pressing a dresser or the like against the diamond grindstone 53 if necessary.

According to the mechanical polishing (high-precision grinding machining) process of the first surface machining step (STEP 130 (1)) and the second surface machining step (STEP 130 (2)), by using one of the highly flat, transfer-less cut surfaces obtained from the cutting and polishing step as a support surface (suction surface) and sequentially applying mechanical polishing (high-precision grinding machining) to the remaining surface, it is possible to obtain a high-quality SiC wafer while preventing so-called transfer, and also to greatly simplify the complex manufacturing process of conventional free abrasive processing, such as multiple lapping steps (one to four times).

More specifically, there is no need to change grindstones for rough grinding and multiple finishing grinds. For example, finishing can be done in a single grinding machining directly with a grindstone of #30,000 or higher, which is not only simple but also has the advantage of being able to secure a larger intrinsic semiconductor layer that can be utilized from the SiC wafer 100.

In the high-precision grinding machining process of the first surface machining step (STEP 130 (1)) and the second surface machining step (STEP 130 (2)), the size of the SiC wafer 100 is currently up to 8 inches, and wafers of various diameters are set according to an area of a grinding head (up to 12 inches if possible) and the high-precision grinding machining process is performed (up to 12 inches).

The above describes the details of the manufacturing method for the SiC wafer of this embodiment. As explained in detail above, according to the manufacturing method and manufacturing device for the SiC wafer of this embodiment, regions of low cutting resistance are actively formed by the concave grooves 11 and the cutting guidelines, and these serve as guides for cutting, thereby allowing the SiC ingot 10 to be cut into slices with high precision at one time using the plurality of wires 40.

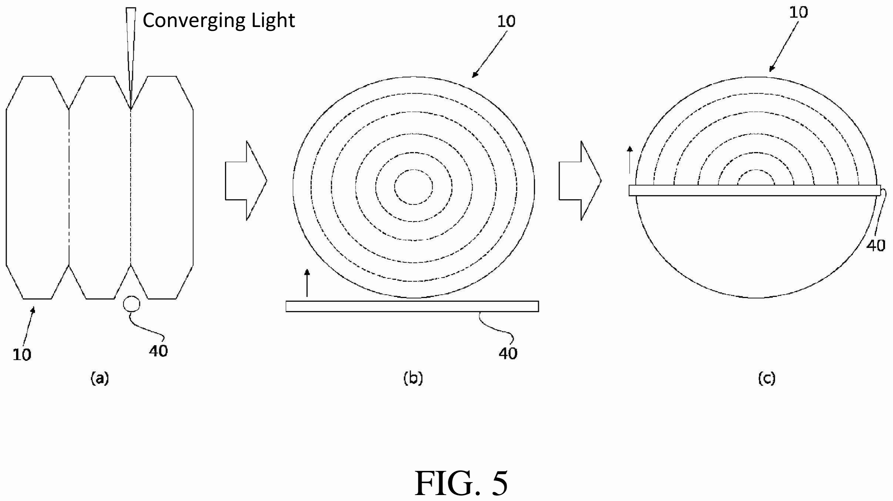

Next, with reference to FIG. 5, a modification example of the cutting guideline will be explained.

Specifically, as shown in FIG. 5(a), the cutting guideline is not limited to introducing a laser beam from the end surface of the SiC ingot 10. A plurality of concentric circular cutting guidelines may be formed on the planned cutting surface by introducing the laser beam from the side surface, as shown in the cross-sectional view of the planned cutting surface in FIG. 5(b). For example, concentric circular cutting guidelines can be easily formed by rotating the SiC ingot 10 around its axis.

In this case as well, as the wire 40, arranged in the concave groove 11, advances while circulating during cutting, the cutting guideline, in addition to the groove 11 in the uncut region, becomes a region of low cutting resistance and serves as a guide for cutting. In this case as well, since the plurality of concentric circular cutting guidelines are denser towards the center of the SiC ingot 10, as shown in FIG. 5(c), it is possible to prevent the wire 40 from bowing and keep it straight.

Note that in the above embodiment, the cutting guidelines are not limited to being aligned with the traveling direction of the wire 40 or being formed concentrically. The cutting guidelines can be formed in any manner as long as the traveling direction of the wire 40 is taken into consideration. For example, a cutting guidelines can be formed in a scanning direction that starts from a cutting end point of the wire 40 and is radial in the advancement and retreat direction of the wire (in this case, the retreat direction).

In this case as well, since the cutting guidelines are denser in the center of the SiC ingot compared to the left and right sides, regions of low cutting resistance are provided in stages from both sides to the center, which prevents the wire 40 from bowing and keeps it straight.

Of course, instead of or in addition to the radial pattern starting from the cutting end point of the wire 40, the cutting guidelines can be formed in a scanning direction that is radially aligned from the cutting start point in the advancement and retreat direction of the wire (in this case, the advancement direction).

In this way, by providing radial cutting guidelines starting from the cutting start point or the cutting end point, cutting at the cutting start point and at the cutting end point becomes possible with almost no cutting resistance, which can significantly improve the cutting finish at the cutting start point and the cutting end point.

Furthermore, the guideline forming step (STEP 110/FIG. 1) of this embodiment may also be applied to thin film machining for backside formation for the purpose of wafer reclamation.

In the manufacturing method for a SiC wafer of this embodiment, a chemical mechanical polishing (CMP) step and a wafer cleaning step may be performed as needed after a series of processes described above.

Furthermore, in this embodiment, the manufacturing method for a semiconductor crystal wafer has been described for the case of manufacturing a SiC wafer from an SiC ingot, but the semiconductor crystal is not limited to SiC and may be gallium arsenide (GaAs), indium phosphide (InP), silicon, or other compound semiconductors.

Also, this embodiment describes the case where the SiC ingot 10 is rotatably supported with its both end surfaces protected by a pair of protective plates 15, 15 in the groove machining step (STEP 100/FIG. 1), but the present invention is not limited to as such. For example, the pair of protective plates 15, 15 may be omitted, and the SiC ingot 10 may be fixed directly to the rotation axis.

Furthermore, machining may be performed with both end surfaces of the SiC ingot 10 protected by a pair of protective plates 15, 15 in steps other than the groove machining step (STEP 100/FIG. 1), for example, in the cutting step (STEP 120/FIG. 1).

Note that this embodiment describes the case where a plurality of concave grooves 11 are formed to surround the entire side surface of the SiC ingot 10 by a groove machining drum grindstone 20 in the groove machining step (STEP 100/FIG. 1), but the groove machining step of STEP 100 may be omitted, and the concave grooves 11 may not be formed.

Also, in this embodiment, an electric discharge machining device, which is an electric discharge wire saw device, was described as an example of the cutting means, but the cutting means is not limited to as such and may be a wire saw device without an electric discharge function, or a cutter device (including those with an electric discharge function). In the case of a cutter device, the cutting blade may be in the shape of a circular ring blade, a hacksaw blade, or the like.

Furthermore, in this embodiment, the cutting guidelines formed in the guideline forming step (STEP 110/FIG. 1) are mainly described as scanning lines that coincide with the cutting direction, but the scanning lines corresponding to the cutting direction are not limited to as such, and may be scanning lines orthogonal to the cutting direction, or may have varying density according to the cutting direction.

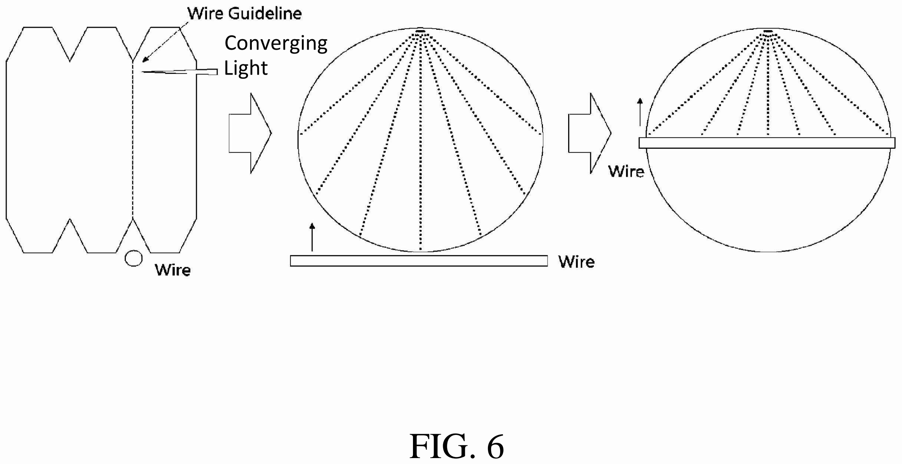

For example, as shown in FIG. 6, the cutting guidelines may be formed as radial scanning lines starting from the cutting end point of the cutting means (the wire of the wire saw device) and extending in the cutting direction (the traveling direction of the wire). By making the scanning lines radial in this way, for example, regions of low cutting resistance are provided in stages from both sides to the center during cutting, which can prevent the central part of the wire from advancing in a bow shape during cutting, and the finish of the final cut portion will be excellent because the final cut portion is a radial point (allowing it to be cut without resistance).

Note that such radial scanning lines may be formed starting from the cutting start point in addition to or instead of starting from the cutting end point of the cutting means (the wire of the wire saw device). In this case, the finish of the cutting start portion will be excellent because the cutting start portion is a radial point (allowing it to be cut without resistance).

### REFERENCE SIGNS LIST

10 SiC ingot (semiconductor crystal ingot)
11 concave grooves
15 protective plate
20 groove machining drum grindstone
21 convex portions
40 wire
50 mechanical polishing device (ultra-high synthetic high-precision grinding device)
51 spindle
52 platen
53 diamond grindstone
54 porous vacuum chuck (suction plate)
100 SiC wafer (semiconductor crystal wafer)
110 one surface
120 the other surface
STEP 100 groove machining step
STEP 110 guideline forming step
STEP 120 cutting step
STEP 130 grinding machining step
STEP 130(1) first surface machining step
STEP 130(2) second surface machining step

## Claims

1. A semiconductor crystal wafer manufacturing device which cuts a semiconductor crystal ingot, that has been ground into a cylindrical shape, into slices as wafers, the device comprising:
a guideline forming means for forming cutting guidelines by focusing a laser beam of a wavelength that is transmissive to the semiconductor crystal ingot to form a focal point and scanning the focal point along a planned cutting surface; and
a cutting means for cutting the planned cutting surface of the semiconductor crystal ingot;
wherein the guideline forming means forms the cutting guidelines on the planned cutting surface as scanning lines that correspond to a cutting direction of the cutting means, and the scanning lines coincide with the cutting direction of the cutting means.

2. The semiconductor crystal wafer manufacturing device of claim 1, wherein the cutting means is a wire electric discharge machining device that advances a wire while circulating the wire around the planned cutting surface and generates an electric discharge from the wire.

3. The semiconductor crystal wafer manufacturing device of claim 1, wherein the cutting means is a cutter device that advances a cutting blade along the planned cutting surface.

4. A semiconductor crystal wafer manufacturing device which cuts a semiconductor crystal ingot, that has been ground into a cylindrical shape, into slices as wafers, the device comprising:
a groove machining drum grindstone for forming a plurality of concave grooves surrounding an entire side surface of the semiconductor crystal ingot, wherein the groove machining drum grindstone has a plurality of convex portions on its side surface corresponding to the plurality of concave grooves;
a wire saw device for cutting the semiconductor crystal ingot into slices by advancing a plurality of wires arranged in the plurality of concave grooves while circulating the plurality of wires; and
a guideline forming means for forming cutting guidelines on each planned cutting surface, including each concave groove formed on the side surface of the semiconductor crystal ingot, by focusing a laser beam of a wavelength transmissive to the semiconductor crystal ingot to form a focal point and scanning the focal point along the planned cutting surface;
wherein the guideline forming means forms the cutting guidelines in a scanning direction that corresponds to a traveling direction of the plurality of wires of the wire saw device, and the scanning direction coincides with the traveling direction of the plurality of wires.

5. The semiconductor crystal wafer manufacturing device of any one of claims 1 to 4, wherein the guideline forming means introduces the laser beam from an end surface of the semiconductor crystal ingot.

6. A semiconductor crystal wafer manufacturing method which cuts a semiconductor crystal ingot, that has been ground into a cylindrical shape, into slices as wafers, the method comprising:
a guideline forming step of forming cutting guidelines by focusing a laser beam of a wavelength transmissive to the semiconductor crystal ingot to form a focal point and scanning the focal point along a planned cutting surface; and
a cutting step of cutting the planned cutting surface of the semiconductor crystal ingot;
wherein the guideline forming step forms the cutting guidelines on the planned cutting surface as scanning lines that correspond to a cutting direction of the cutting step, and the scanning lines coincide with the cutting direction of the cutting step.

7. A semiconductor crystal wafer manufacturing method which cuts a semiconductor crystal ingot, that has been ground into a cylindrical shape, into slices as wafers, the method comprising:
a groove machining step of forming a plurality of concave grooves surrounding an entire side surface of the semiconductor crystal ingot;
a guideline forming step of forming cutting guidelines on each planned cutting surface, including each concave groove formed on the side surface of the semiconductor crystal ingot in the groove machining step, by focusing a laser beam of a wavelength transmissive to the semiconductor crystal ingot to form a focal point and scanning the focal point along the planned cutting surface; and
a cutting step of cutting the semiconductor crystal ingot into slices by advancing a plurality of wires arranged in the plurality of concave grooves formed in the groove machining step while circulating the plurality of wires,
wherein the guideline forming step forms the cutting guideline in a scanning direction that corresponds to a traveling direction of the plurality of wires in the cutting step, and the scanning direction coincides with the traveling direction of the plurality of wires.
